Europäisches Patentamt

European Patent Office

Office européen des brevets

(19)

(11) **EP 1 450 167 A1**

(12) **EUROPÄISCHE PATENTANMELDUNG**

(43) Veröffentlichungstag:
**25.08.2004 Patentblatt 2004/35**

(51) Int Cl.$^7$: **G01R 17/10**

(21) Anmeldenummer: **03004023.2**

(22) Anmeldetag: **24.02.2003**

(84) Benannte Vertragsstaaten:
**AT BE BG CH CY CZ DE DK EE ES FI FR GB GR HU IE IT LI LU MC NL PT SE SI SK TR**
Benannte Erstreckungsstaaten:
**AL LT LV MK RO**

(71) Anmelder: **ELMOS Semiconductor AG**
**44227 Dortmund (DE)**

(72) Erfinder: **Hartzsch, Jörg**
**44287 Dortmund (DE)**

(74) Vertreter: **Hilleringmann, Jochen, Dipl.-Ing. et al**
**Patentanwälte**
**von Kreisler-Selting-Werner,**
**Bahnhofsvorplatz 1 (Deichmannhaus)**
**50667 Köln (DE)**

(54) **Verfahren und Vorrichtung zum Messen des Widerstandswertes eines elektronischen Bauelements**

(57) Verfahren zur Bestimmung des Widerstandswert ($R_x$) eines elektrischen Bauelements (22), dessen Widerstandswert ($R_x$) zwischen einem bekannten Maximalwert ($R_{XMAX}$) und einem bekannten Minimalwert ($R_{XMIN}$) liegt, wird eine Messbrücke (36) verwendet, in deren ersten Brückenzweig (38) das Bauelement (22) und ein bekannter Referenzwiderstand ($R_R$) geschaltet sind und in deren zweiten Brückenzweig (40) drei jeweils bekannte Widerstände ($R_1$, $R_2$, $R_3$) geschaltet sind.

Der erste Brückenzweig (38) weist einen Widerstandsverbindungspunkt ($K_1$) zwischen dem Referenzwiderstand ($R_R$) und dem Bauelement (22) auf und der zweite Brückenzweig (40) einen ersten Widerstandsverbindungspunkt ($K_2$) zwischen dem mit dem Bauelement (22) verbundenen ersten Widerstand ($R_1$) und dem zweiten Widerstand ($R_2$) sowie einen zweiten Widerstandsverbindungspunkt ($K_3$) zwischen dem zweiten Widerstand ($R_2$) und dem mit dem Referenzwiderstand verbundenen dritten Widerstand ($R_3$).

Die Werte des Referenzwiderstandes ($R_R$) des ersten Brückenzweiges (38) und der drei Widerstände ($R_1$, $R_2$, $R_3$) des zweiten Brückenzweiges (40) sind derart gewählt, dass (i) das Potential des Widerstandsverbindungspunkt des ersten Brückenzweiges (38) gleich dem Potential des ersten Widerstandsverbindungspunktes ($K_1$) des zweiten Brückenzweiges (40) ist, wenn das Bauelement (22) seinen Minimalwiderstandswert ($R_{XMIN}$) aufweist, und (ii) das Potential des Widerstandsverbindungspunkts ($K_1$) des ersten Brückenzweiges (38) gleich dem Potential des zweiten Widerstandsverbindungspunkts ($K_3$) des zweiten Brückenzweiges (40) ist, wenn das Bauelement (22) seinen Maximalwiderstandswert ($R_{XMAX}$) aufweist.

$$R_{XMIN} \le R_X \le R_{XMAX}$$

$$\frac{R_{XMAX}}{R_R + R_{XMAX}} = \frac{R_1 + R_2}{R_1 + R_2 + R_3}$$

$$\frac{R_{XMIN}}{R_R + R_{XMIN}} = \frac{R_1}{R_1 + R_2 + R_3}$$

Fig.1

EP 1 450 167 A1

**Beschreibung**

Die Erfindung betrifft ein Verfahren und eine Vorrichtung zur Bestimmung des (unbekannten) Widerstandswerts eines elektrischen Bauteils, dessen Widerstandswert zwischen einem (bekannten) Maximalwert und einem (bekannten) Minimalwert liegt. Ferner betrifft die Erfindung eine elektrische Schaltung mit einer zuvor erwähnten Vorrichtung.

Sofern elektrische oder elektromechanische Systeme eine Stromvermessung erfordern, wird diese üblicherweise so durchgeführt, dass der zu messende Strom über einen Shunt-Widerstand geführt wird. Der dabei entstehende Spannungsabfall kann messtechnisch ermittelt und bei bekanntem Widerstandswert in einen Strom umgerechnet werden. Erforderlich ist also die genaue Kenntnis des Widerstandswerts des Shunt-Widerstands. Shunt-Widerstände sind jedoch kostenintensiv und unterliegen relativ hohen Fertigungstoleranzen. Zu dem sind oftmals Montageprobleme zu lösen. Schließlich ist der Widerstandswert eines Shunt-Widerstands temperaturabhängig.

Von daher ist es von, Vorteil, wenn man für die Stromvermessung in einem elektrischen oder elektromechanischem System den Spannungsabfall über einem in diesem Systems vorhandenen Bauelement nutzen kann. Diesbezüglich gilt es aber zu bedenken, dass der Widerstandswert eines derartigen Bauteils innerhalb eines an sich bekannten Widerstandswertbereichs liegen kann. Von daher ist es also erforderlich, den Widerstandswert des Bauelements vor Aufnahme der bestimmungsgemäßen Nutzung des elektrischen oder elektromechanischen Systems zu bestimmen, wobei der einzig bekannte Parameter darin zu sehen ist, dass der mögliche Minimal- und der mögliche Maximalwert für den Widerstand des betreffenden elektrischen Bauelements bekannt ist.

Eine Aufgabe der Erfindung ist es daher, ein Verfahren und eine Vorrichtung zur Bestimmung des Widerstandswerts eines elektrischen Bauelements anzugeben, von dem lediglich der maximal mögliche und der minimal mögliche Widerstandswert bekannt sind.

Zur Lösung dieser Aufgabe wird mit der Erfindung ein Verfahren zur Bestimmung des Widerstandswerts eines elektrischen Bauelements vorgeschlagen, dessen Widerstandswert zwischen einem bekannten Maximal- und einem bekannten Minimalwert liegt, und zwar mit Hilfe einer Messbrücke.

Es handelt sich hierbei um ein Verfahren zur Bestimmung des Widerstandswert $R_x$ eines elektrischen Bauelements, dessen Widerstandswert $R_x$ zwischen einem bekannten Maximalwert $R_{XMax}$ und einem bekannten Minimalwert $R_{xMIN}$ liegt, mit Hilfe einer Messbrücke, in deren ersten Brückenzweig das Bauelement und ein bekannter Referenzwiderstand $R_R$ geschaltet sind und in deren zweiten Brückenzweig drei jeweils bekannte Widerstände $R_1$, $R_2$, $R_3$ geschaltet sind, wobei der erste Brückenzweig einen Widerstandsverbindungspunkt $K_1$ zwischen dem Referenzwiderstand $R_R$ und dem Bauelement aufweist und der zweite Brückenzweig einen ersten Widerstandsverbindungspunkt $K_2$ zwischen dem mit dem Bauelement verbundenen ersten Widerstand $R_1$ und dem zweiten Widerstand $R_2$ sowie einen zweiten Widerstandsverbindungspunkt $K_3$ zwischen dem zweiten Widerstand $R_2$ und dem mit dem Referenzwiderstand verbundenen dritten Widerstand $R_3$ aufweist und wobei die Werte des Referenzwiderstandes $R_R$ des ersten Brückenzweiges und der drei Widerstände $R_1$, $R_2$, $R_3$ des zweiten Brückenzweiges derart gewählt sind, dass (i) das Potential des Widerstandsverbindungspunkt $K_1$ des ersten Brückenzweiges gleich dem Potential des ersten Widerstandsverbindungspunktes $K_2$ des zweiten Brückenzweiges ist, wenn das Bauelement seinen Minimalwiderstandswert $R_{XMIN}$ aufweist, und (ii) das Potential des Widerstandsverbindungspunkts $K_1$ des ersten Brückenzweiges gleich dem Potential des zweiten Widerstandsverbindungspunkts $K_3$ des zweiten Brückenzweiges ist, wenn das Bauelement seinen Maximalwiderstandswert $R_{XMAX}$ aufweist, wobei bei dem Verfahren

- durch beide Brückenzweige der Messbrücke ein Messstrom $I_T$ fließt, und
- anhand der Verhältnisse der Differenzspannungen zwischen den Widerstandsverbindungspunkten $K_1$, $K_2$, $K_3$, anhand des Minimalwiderstandswertes $R_{XMIN}$ und anhand des Maximalwiderstandswertes $R_{XMAX}$ der aktuelle Widerstandswert $R_x$ des Bauelements ermittelt wird.

Vorteilhafte Weiterbildungen, des erfindungsgemäßen Verfahrens sind jeweils in den Unteransprüchen 2 bis 12 angegeben.

Eine Vorrichtung, mit der sich das zuvor beschriebene Verfahren durchführen lässt, ist in Anspruch 13 angegeben. Vorteilhafte Weiterbildungen dieser Vorrichtung sind in den Ansprüchen 14 bis 23 angegeben.

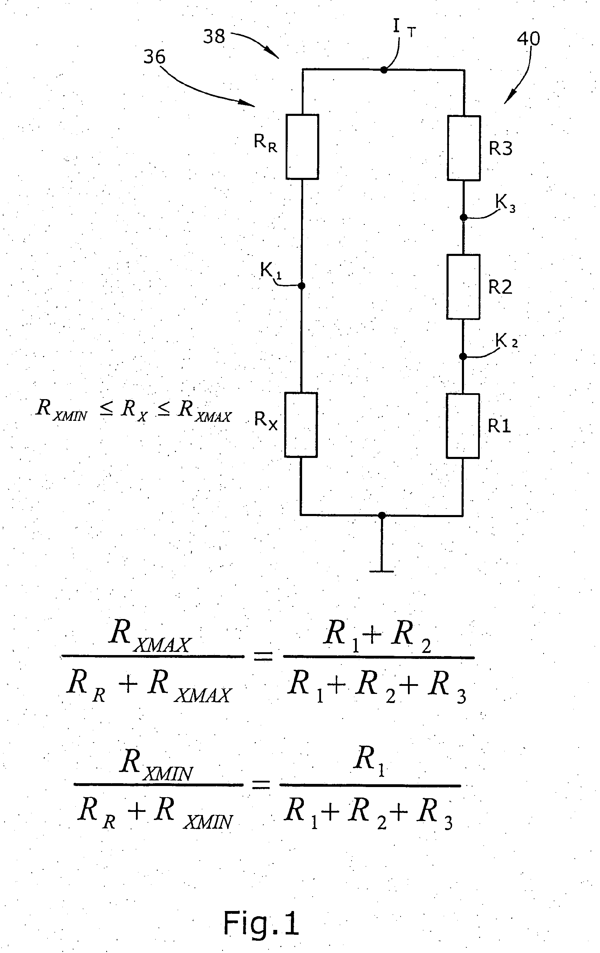

Bei der erfindungsgemäßen Bestimmung des Widerstandswerts eines elektrischen Bauelements wird eine Messbrücke eingesetzt, deren Aufbau ähnlich dem einer Wheatstonschen Messbrücke ist, jedoch mit der Ausnahme, dass keiner der Widerstände veränderbar ist. In dem ersten der beiden Brückenzweige dieser Messbrücke befindet sich neben dem Bauelement, dessen Widerstand bestimmt werden soll, ein bekannter Referenzwiderstand. Im zweiten Brückenzweig der Messbrücke befindet sich eine Reihenschaltung von drei bekannten Widerständen. Die Werte der bekannten Widerstände der Messbrücke werden so, wie oben beschrieben, festgelegt. Die erfindungsgemäße Messbrücke ist in Fig. 1 wiedergegeben. Vom zu bestimmenden Widerstand $R_x$ ist lediglich bekannt, dass dieser zwischen $R_{XMIN}$ und $R_{XMAX}$ liegt. Nachdem der Referenzwiderstand $R_R$ des ersten Brückenzweiges und einer der drei Widerstände des zweiten Brückenzweiges, in diesem Fall der Widerstand $R_3$ vorgegeben worden sind, lassen sich die Werte für die Widerstände $R_1$ und $R_2$ aus den nachfolgend genannten beiden Gleichungen errechnen:

$$R_{XMAX} / (R_R + R_{XMAX}) = (R_1 + R_2) / (R_1 + R_2 + R_3)$$

$$R_{XMIN} / (R_R + R_{XMIN}) = R_1 / (R_1 + R_2 + R_3)$$

Eine derart dimensionierte Messbrücke lässt sich nun beim Einprägen eines Teststroms $I_T$ dazu verwenden, den Widerstandswert von $R_x$, also den Widerstandswerts eines elektrischen Bauelements zu bestimmen. Dazu werden die Differenzspannungen zwischen den Knotenpunkten $K_1$ und $K_2$, $K_1$ und $K_3$ bzw. $K_2$ und $K_3$ messtechnisch ermittelt. Zwei dieser Differenzspannungen müssen ermittelt werden, um daraus den Widerstandswert von $R_x$ ermitteln zu können (zum Beispiel gemäß Dreisatz).

Ist beispielsweise die Spannungsdifferenz zwischen den Knotenpunkten $K_1$ und $K_2$ gleich 0 Volt, so ist der Wert des Widerstandes $R_x$ gleich seinem Minimalwert. Ist dagegen die Differenzspannung zwischen den Knotenpunkten $K_1$ und $K_3$ gleich 0 Volt, so ist der Wert des Widerstandes $R_x$ gleich dem Maximalwert. Bei Differenzspannungswerten zwischen den Knotenpunkten $K_1$ und $K_2$ bzw. $K_1$ und $K_3$ von ungleich 0 Volt, ist der Wert des Widerstandes $R_x$ gleich dem entsprechenden Prozentualanteil des Maximal- bzw. Minimalwerts.

Auf die oben beschriebene Weise lässt sich also der Wert des Widerstandes $R_x$, das heißt der Widerstandswert eines elektrischen Bauelements messtechnisch bestimmen, wenn von dem Bauelement lediglich bekannt ist, dass sein Widerstandswert zwischen einem bekannten Maximal- und einem bekannten Minimalwert liegt.

Durch das erfindungsgemäße Verfahren ist es also möglich, für eine Strommessung innerhalb eines elektrischen oder elektronischen bzw. elektromechanischen Systems als Shunt-Widerstand ein Bauelement dieses Systems zu nutzen, von dem lediglich der maximal zulässige Widerstandswertebereich bekannt ist. Bei dem damit verwendbaren Bauelement kann es sich dann also beispielsweise um einen Verpolschutztransistor oder auch einen eine Last schaltenden Transistor (Highside- bzw. Lowside-Schalter) handeln, von dem der Minimal- und der Maximalwert des EIN-Widerstandes bekannt ist. Aber auch jedes andere einen Ohmschen Anteil aufweisende Bauelement, das heißt auch ein Widerstand ist als zu vermessendes Bauelement verwendbar.

Im Regelfall sind die erfindungsgemäß als Ersatz für einen Shunt-Widerstand verwendbaren elektrischen, Bauelemente einer Schaltung, wie beispielsweise ein Verpolschutztransistor oder eine Last schaltender Transistor temperaturabhängig, was ihren EIN-Widerstand angeht. Es ist daher zweckmäßig, das zuvor beschriebene erfindungsgemäße (Kalibrier-)Verfahren dann durchzuführen, wenn sich die Temperatur des als Shunt-Widerstand verwendeten Bauelements verändert. Die Temperaturermittlung kann messtechnisch durch einen Temperatursensor erfolgen. Alternativ ist es aber auch möglich, anhand der elektrischen Belastungen, insbesondere anhand des das elektrische Bauelement durchfließenden Stromes, auf die thermische Belastung und damit auf die Erwärmung des elektrischen Bauelements rückzuschließen. Eine weitere Möglichkeit der Widerstandsbestimmung des temperaturabhängigen elektrischen Bauelements besteht darin, dass Kalibrierverfahren zyklisch nach Ablauf jeweils einer Zeitspanne durchzuführen, d.h. den zu bestimmenden Widerstandswert jeweils aktuell zu bestimmen.

Die Erfindung wird nachfolgend anhand der Zeichnung näher erläutert. Im Einzelnen zeigen:

Fig. 1        die nach der Erfindung vorgesehene Widerstands-Messbrücke und

Fig.2 bis 4     unterschiedliche Varianten einer erfindungsgemäßen Schaltung zur Vermessung der Ohmschen Widerstände von Transistoren der Schaltung bzw. eines Widerstandes der Schaltung, die während der Applikation der Strommessung dienen.

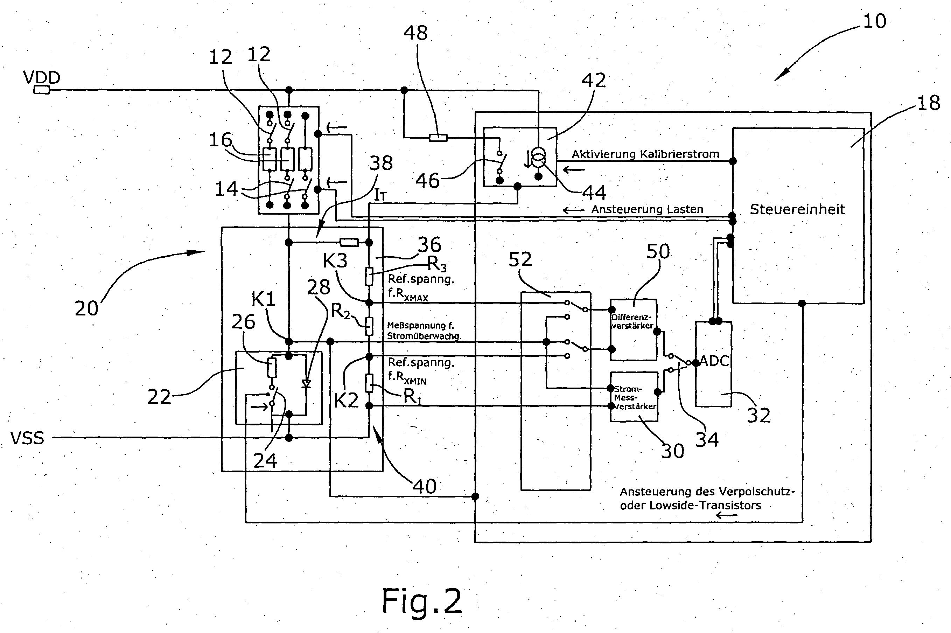

Ein erstes Ausführungsbeispiel eines elektrischen bzw. elektromechanischen Systems 10, bei dem für die Strommessung im Betrieb ein Bauelement des Systems 10, in diesem Fall ein Verpolschutztransistor verwendet wird, der zuvor erfindungsgemäß vermessen worden ist, ist in Fig. 2 dargestellt. Das System 10 umfasst eine elektrische Schaltung, mit der in diesem Ausführungsbeispiel Highside- und Lowside-Schalter 12, 14 angesteuert werden, die ihrerseits eine Last 16 treiben. Die Highside- und Lowside-Schalter 12, 14 werden über eine Steuereinheit 18 angesteuert. Im Energieversorgungspfad des Laststromkreises 20 befindet sich ein Verpolschutztransistor 22, von dem in Fig. 2 das Ersatzschaltbild bestehend aus einem Schalter 24, einem EIN-Widerstand 26 und einer zu beiden parallel geschalteten Diode 28 dargestellt ist. Auch der Verpolschutztransistor 22 wird über die Steuereinheit 18 angesteuert.

Erfindungsgemäß wird nun dieser Verpolschutztransistor 22 bzw. genauer gesagt sein EIN-Widerstand 26 (nachfolgend auch mit $R_x$ bezeichnet) für die Strommessung verwendet. Dazu wird von einem Strommessverstärker 30 der Spannungsabfall über dem EIN-Widerstand $R_x$ erfasst und mittels eines mit dem Ausgang des Verstärkers 30 verbundenen A/D-Wandlers 32 der Steuereinheit 18 zugeführt. Bei bekanntem Wert für den EIN-Widerstand $R_x$ kann dann anhand des gemessenen Spannungsabfalls der Strom errechnet werden. Während der Applikation verbindet also der Schalter 34 zwischen dem Strommessverstärker 30 und dem A/D-Wandler 32 beide Einheiten (siehe gestrichelte Linie in Fig. 2).

Der Schaltzustand des Schalters 34 wird ebenfalls über die Steuereinheit gesteuert, was in Fig.2 jedoch nicht dargestellt ist. Um nun den EIN-Widerstand $R_x$, dessen Minimalwert und dessen Maximalwert bekannt sind, dessen exakter Wert jedoch unbekannt ist, vermessen zu können, ist die zuvor beschriebene Schaltung des Systems 10 um die nachfolgend aufgeführten Bauteile und Schaltungskomponenten ergänzt. Hier ist zunächst einmal die Einbindung des Verpolschutztransistors 22 in eine abgewandelte Widerstandsmessbrücke 36 zu nennen. Dabei ist in Reihe mit dem EIN-Widerstand $R_x$ ein Referenzwiderstand $R_R$ geschaltet. Parallel zu dieser Reihenschaltung aus Referenzwiderstand $R_R$ und Verpolschutztransistors 22 geschaltet ist eine weitere Widerstandsreihenschaltung, die die drei Widerstände $R_1$, $R_2$ und $R_3$ umfasst. Der erste Brückenzweig der Messbrücke 36 umfasst also den Referenzwiderstand $R_R$ und den Verpolschutztransistor 22, während der zweite Brückenzweig 40 die drei Widerstände $R_1$, $R_2$ und $R_3$ umfasst. Zwischen den einzelnen Widerständen ergeben sich dann die Knoten- bzw. Widerstandsverbindungspunkte $K_1$, $K_2$ und $K_3$.

Zur Einprägung eines Mess- bzw. Kalibrierstroms in die Messbrücke 36 dient die Einheit 42, die entweder als Stromquelle 44 ausgebildet ist oder einen Schalter 46 aufweist, bei dessen Schließen über einen Widerstand 48 Strom in die Messbrücke 36 eingeprägt wird. Die Aktivierung des Kalibrierstroms erfolgt durch die Steuereinheit 18.

Darüber hinaus bedarf es für die Vermessung des EIN-Widerstandes $R_x$ noch eines Differenzverstärkers 50, der über einen vorgeschalteten Multiplexer 52 wahlweise die Differenzspannungen zwischen den Widerstandsverbindungspunkten $K_1$ und $K_2$, $K_1$ und $K_3$ bzw. $K_2$ und $K_3$ ermittelt. Das Ausgangssignal des Differenzverstärkers 50 wird der Steuereinheit 18 über den A/D-Wandler 32 zugeführt. Hierfür nimmt der Schalter 34 seine in Figur 2 in durchgezogener Linie dargestellte Schaltposition an.

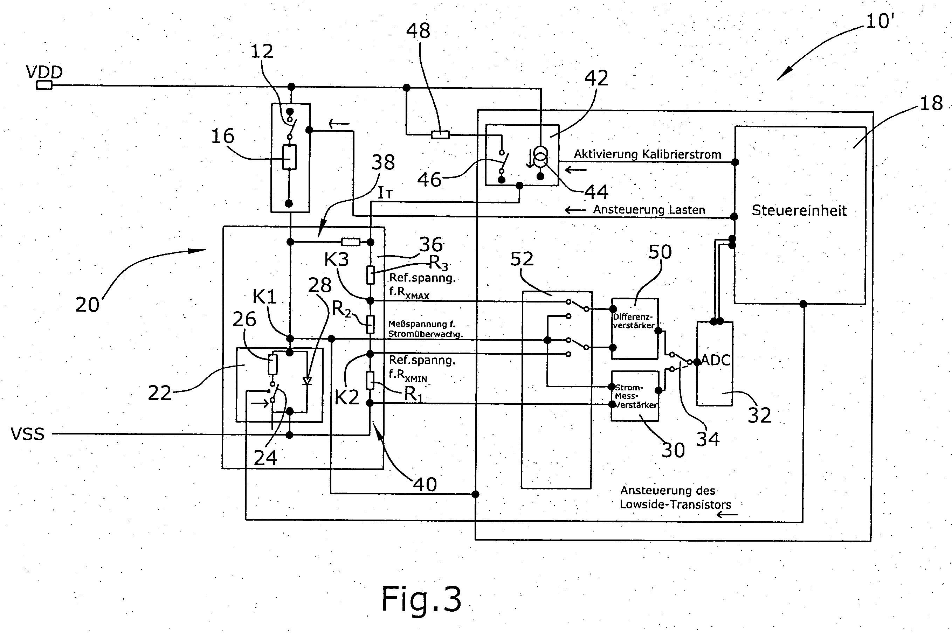

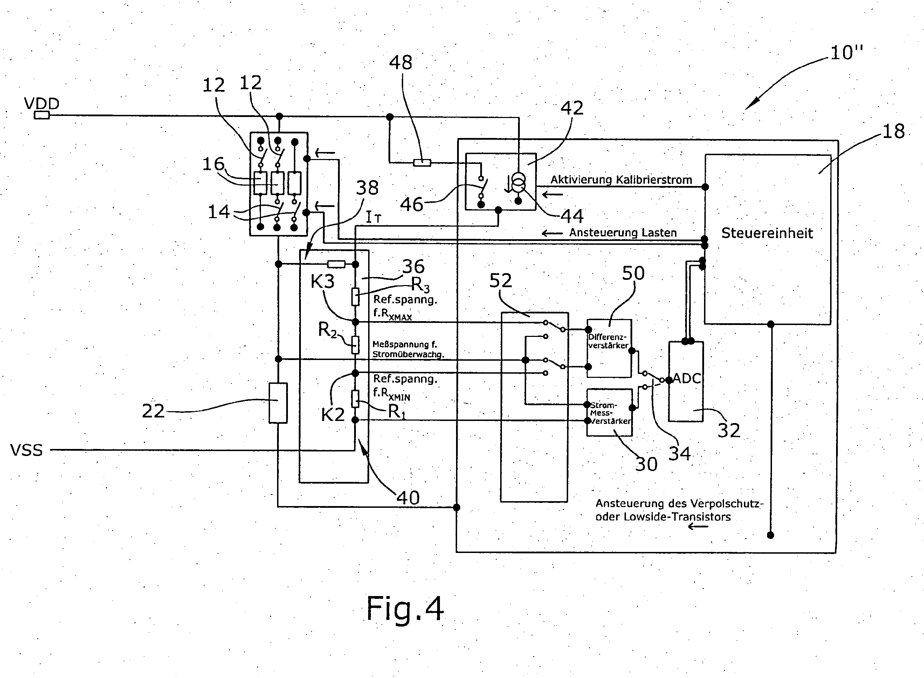

Die Fign. 3 und 4 zeigen zwei zum System 10 gemäß Fig. 2 alternative Konzepte, bei denen gemäß Fig. 3 ein Lowside-Schalter als Shunt-Widerstand für die Strommessung und in Fig. 4 ein Ohmscher Widerstand als Shunt-Widerstand verwendet wird. Der grundsätzliche Aufbau dieser beiden Alternativsysteme 10' und 10'' ist jedoch der gleiche wie anhand von Fig. 2 beschrieben.

Für sämtliche Varianten gilt bezüglich der Dimensionierung der noch festzulegenden Widerstände $R_1$, $R_2$, $R_3$ und $R_R$ der Widerstandsmessbrücke 36 unter Bezugnahme auf das im Zusammenhang mit der Beschreibung von Fig. 1 gesagte Folgendes.

Die einzigen festliegenden Größen der Widerstandsmessbrücke 36 sind der Maximal- und der Minimalwert $R_{XMAX}$ und $R_{XMIN}$ des Widerstandes $R_x$.

Zunächst werden nun der Widerstandswert für den Widerstand $R_R$ sowie der Kalibrierstrom festgelegt. Beide Parameter sind so zu wählen, dass sich die während der Kalibration ergebende Spannung am Widerstandsverbindungspunkt $K_3$ am oberen Rand des durch den Differenzverstärker 50 verarbeitbaren Spannungsbereich befindet.

Danach wird die Summe der Widerstände $(R_1 + R_2 + R_3)$ festgelegt. Diese Summe kann durchaus recht hochohmig sein, wobei wichtig ist, dass Eingangsströme des Strommessverstärkers 30 vernachlässigbar bleiben.

Die Berechnung der Werte für die Widerstände $R_1$ und $R_2$ erfolgt dann durch Auflösung der zuvor genannten Gleichungen, wöbei gilt:

$$R_1 = R_{XMIN} \times (R_1 + R_2 + R_3) / (R_R + R_{XMIN})$$

$$R_2 = R_{XMAX} \times (R_1 + R_2 + R_3) / (R_R + R_{XMAX}) - R_1$$

$$R_3 = (R_1 + R_2 + R_3) - R_1 - R_2$$

Nachdem auf die zuvor beschriebene Weise die Dimensionierung der Widerstände der Messbrücke 36 erfolgt ist, wird nun die Vermessung des Widerstandes $R_x$ durchgeführt.

Hierzu wird ein Kalibrierstrom $I_T$ in die Widerstandsmessbrücke 36 eingeprägt. Dies erfolgt alternativ entweder durch Schließen des Schalters 46, wodurch über den Referenzwiderstand $R_R$ und den Verpolschutztransistor 22 (Fig. 2) ein definierter Kalibrierstrom fließt. Alternativ kann der Kalibrierstrom auch mittels einer Stromquelle 44 der Einheit 42 erzeugt werden. Ein vernachlässigbar geringer Anteil des Kalibrierstroms wird über den zweiten Brückenzweig 40 der Messbrücke 36 geführt. Dieser zweite Brückenzweig 40 generiert die Minimal- und Maximalreferenzen des zu vermessenden Widerstandes $R_x$, wie oben erläutert ist.

Über den Differenzverstärker 50 mit schaltbarem Eingangs-Multiplexer 52 können nun folgende vier Messun-

gen durchgeführt werden:

a) $\Delta U(K_1 - K_2)$
b) $\Delta U(K_3 - K_1)$
c) $\Delta U(K_3 - K_2)$
d) $\Delta U(K_1 - K_1)$ zum Offset-Abgleich

Varianten

d.1) Offsets können direkt mit der Messtechnik ermittelt werden, sofern der Differenzverstärker 50 und der A/D-Wandler 32 negative wie positive Spannungsdifferenzen verarbeiten können
d.2) Der Differenzverstärker 50 erhält designseitig einen typisch positiven Offset (damit ist dieser immer messbar, auch bei nur unipolar arbeitendem A/D-Wandler 32)

Zur Minimierung von Fehlern durch Nichtlinearitäten des Differenzverstärkers 50 und des A/D-Wandlers 32 (insbesondere im Bereich kleiner Eingangsspannungen) sollten zweckmäßigerweise folgende Verfahren angewendet werden:

1. Es werden alle vier möglichen Messungen 3)a bis 3d) durchgeführt.
2. Von allen vier Messwerten wird der Offset $\Delta U(K_1 - K_1)$ subtrahiert.
3. Es wird ermittelt, welcher der beiden Messwerte a) oder b) der größere ist.
4. Mit diesem größeren Wert wird per Dreisatz ermittelt, bei wieviel Prozent zwischen unterer Referenz ($K_2$) und oberer Referenz ($K_3$) die Spannung an $K_1$ gemessen wurde.

4.a) Wenn $\Delta U(K_3 - K_1) > \Delta U(K_1 - K_2)$

$$\# \Delta U \% = 100 \times \Delta U(K_3 - K_2) - \Delta U(K_3 - K_1) / \Delta U(K_3 - K_2)$$

4.b) Wenn $\Delta U(K_3 - K_1) < \Delta U(K_1 - K_2)$

$$\# \Delta U\% = 100 \times \Delta U(K_1 - K_2) / \Delta U(K_3 - K_2)$$

Die absoluten Spannungen, bezogen auf VSS-Potential, sind hierbei unwichtig. Daher ist weder ein exakter Kalibrierstrom noch ein exakter Verstärkungsfaktor notwendig. Beide Parameter müssen nur über die drei Messungen hinweg konstant bleiben.
5. Aus der prozentualen Angabe $\Delta U \%$ lässt sich nun ebenfalls per Dreisatz der zu bestimmende Widerstand $R_x$ errechnen. Im Spannungsteiler entspricht das Verhältnis der Widerstandswerte dem Verhältnis der an den Widerständen abfallenden Spannungen. Es gilt also:

$$R_X = R_{XMIN} + \Delta U \% \times (R_{XMAX} - R_{XMIN}) / 100$$

Die Werte $R_{XMAX}$ und $R_{XMIN}$ sind dem System bekannt. Sie stellen das obere Ende und untere Ende des messbaren Widerstandsbereichs dar und werden vom Entwickler festgelegt.
Der Steuereinheit 18 ist nun der Widerstandswert $R_x$ der als Shunt genutzten Struktur bekannt.
Fließt nun in der laufenden Applikation ein Strom durch diesen Shunt $R_x$, so wird der Spannungsabfall über den Strommessverstärker 30 an den A/D-Wandler 32 und die Steuereinheit 18 übertragen. Diese kann nun aus dem Spannungsabfall und dem bekannten Widerstandswert $R_x$ die Stromaufnahme der Applikation errechnen.

**Patentansprüche**

**1.**  Verfahren zur Bestimmung des Widerstandswert ($R_x$) eines elektrischen Bauelements (22), dessen Widerstandswert (Rx) zwischen einem bekannten Maximalwert ($R_{XMAX}$) und einem bekannten Minimalwert ($R_{XMIN}$) liegt, mit Hilfe einer Messbrücke (36), in deren ersten Brückenzweig (38) das Bauelement (22) und ein bekannter Referenzwiderstand ($R_R$) geschaltet sind und in deren zweiten Brückenzweig (40) drei jeweils bekannte Widerstände ($R_1$, $R_2$, $R_3$) geschaltet sind,

- wobei der erste Brückenzweig (38) einen Widerstandsverbindungspunkt ($K_1$) zwischen dem Referenzwiderstand ($R_R$) und dem Bauelement (22) aufweist und der zweite Brückenzweig (40) einen ersten Widerstandsverbindungspunkt ($K_2$) zwischen dem mit dem Bauelement (22) verbundenen ersten Widerstand ($R_1$) und dem zweiten Widerstand ($R_2$) sowie einen zweiten Widerstandsverbindungspunkt ($K_3$) zwischen dem zweiten Widerstand ($R_2$) und dem mit dem Referenzwiderstand verbundenen dritten Widerstand ($R_3$) aufweist und wobei die Werte des Referenzwiderstandes ($R_R$) des ersten Brückenzweiges (38) und der drei Widerstände ($R_1$, $R_2$, $R_3$) des zweiten Brückenzweiges (40) derart gewählt sind, dass (i) das Potential des Widerstandsverbindungspunkt ($K_1$) des ersten Brückenzweiges (38) gleich dem Potential des ersten Widerstandsverbindüngspunktes ($K_2$) des zweiten Brückenzweiges (40) ist, wenn das Bauelement (22) seinen Minimalwiderstandswert ($R_{XMIN}$) aufweist, und (ii) das Potential des Widerstandsverbindungspunkts ($K_1$) des ersten Brückenzweiges (38) gleich dem Potential des zweiten Widerstandsverbindungspunkts ($K_3$) des zweiten Brückenzweiges (40) ist, wenn das Bauelement (22) seinen Maximalwiderstandswert ($R_{XMAX}$) aufweist,
- wobei bei dem Verfahren

  - durch beide Brückenzweige (38,40) der Messbrücke (36) ein Messstrom ($I_T$) fließt und
  - anhand der Verhältnisse der Spannungsdifferenzen zwischen den Widerstandsverbindungspunkten ($K_1$, $K_2$, $K_3$) sowie anhand des Mimimalwiderstandswertes ($R_{XMIN}$) und des Maximalwiderstandswerts ($R_{XMAX}$) der aktuelle Widerstandswert ($R_x$) des Bauelements (22) ermittelt wird.

2. Verfahren nach Anspruch 1, **dadurch gekennzeichnet, dass** das Bauelement (22) ein Transistor ist und dass der zu bestimmende Widerstand ($R_x$) der EIN-Widerstand (26), des Transistors ist.

3. Verfahren nach Anspruch 2, **dadurch gekennzeichnet, dass** der Transistor ein Verpolschutztransistor (22) oder ein eine Last schaltender Transistor einer elektrischen Schaltung ist.

4. Verfahren nach, Anspruch 1, **dadurch gekennzeichnet, dass** das Bauelement (22) ein Widerstand ist.

5. Verfahren nach einem der Ansprüche 1 bis 4, **dadurch gekennzeichnet, dass** das Verfahren von einer Ansteuereinheit (18) automatisch nach dem Einschalten einer Versorgungsspannung (VDD) durchgeführt wird.

6. Verfahren nach einem der Ansprüche 1 bis 4, **dadurch gekennzeichnet, dass** das Verfahren automatisch bei Änderung der Temperatur des Bauelements (22), dessen Widerstandswert ($R_x$) zu bestimmen ist, durchgeführt wird.

7. Verfahren nach Anspruch 6, **dadurch gekennzeichnet, dass** die Durchführung des Verfahrens nach Änderung der Umgebungstemperatur des elektrischen Bauelements (22) oder durch Eigenerwärmung des elektrischen Bauelements (22) aufgrund von elektrischer Belastung erfolgt, welche durch Strommessung ermittelt wird.

8. Verfahren nach einem der Ansprüche 1 bis 4, **dadurch gekennzeichnet, dass** das Verfahren zyklisch nach Ablauf jeweils einer gewissen Zeitspanne durchgeführt wird.

9. Verfahren nach einem der Ansprüche 1 bis 8, **dadurch gekennzeichnet, dass** die Differenzspannungen direkt messtechnisch ermittelt werden, und zwar vorzugsweise mit Hilfe eines Differenzverstärkers (50).

10. Verfahren nach einem der Ansprüche 1 bis 8, **dadurch gekennzeichnet, dass** die Differenzspannungen durch Subtraktion von Einzelspannungen zwischen den Widerstandsverbindungspunkten ($K_1$, $K_2$, $K_3$) und einem gemeinsamen Bezugspotential ermittelt werden.

11. Verfahren nach Anspruch 10, **dadurch gekennzeichnet, dass** die Einzelspannungen vor der Subtraktion verstärkt werden oder dass die sich aus der Subtraktion der Einzelspannungen ergebende Differenzspannungen verstärkt werden.

12. Vorrichtung zur Bestimmung des Widerstandswert eines elektrischen Bauelements (22), dessen Widerstand $R_x$ zwischen einem bekannten Maximalwert ($R_{XMAX}$) und einem bekannten Minimalwert ($R_{XMIN}$) liegt, mit

- einer Messbrücke (36), in deren ersten Brückenzweig (38) das Bauelement (22) und ein bekannter Referenzwiderstand ($R_R$) geschaltet sind und in deren zweiten Brückenzweig (40) drei jeweils bekannte Widerstände ($R_1$, $R_2$, $R_3$) geschaltet sind,
- wobei der erste Brückenzweig (38) einen Widerstandsverbindungspunkt ($K_1$) zwischen dem Referenzwiderstand ($R_R$) und dem Bauelement (22) aufweist und der zweite Brückenzweig (40) einen ersten Widerstandsverbindungspunkt ($K_2$) zwischen dem mit dem Bauelement (22) verbundenen ersten Widerstand ($R_1$) und dem zweiten Widerstand ($R_2$) sowie einen zweiten Widerstandsverbindungspunkt ($K_3$) zwischen dem zweiten Widerstand ($R_2$) und dem mit dem Referenzwiderstand verbundenen dritten Widerstand ($R_3$) aufweist und
- wobei die Werte des Referenzwiderstandes ($R_R$) des ersten Brückenzweiges (38) und der drei Widerstände ($R_1$, $R_2$, $R_3$) des zweiten Brückenzweiges (40) derart gewählt sind, dass (i) das Potential des Widerstandsverbindungspunkts ($K_1$) des ersten Brückenzweiges (38) gleich dem Potential des ersten Widerstandsverbindungspunktes ($K_2$) des zweiten Brückenzweiges (40) ist, wenn das Bauelement (22) seinen Minimalwiderstandswert ($R_{XMIN}$) aufweist, und (ii) das Potential des Widerstandsverbindungspunkts ($K_1$) des ersten Brückenzweiges (38) gleich dem Potential des zweiten Widerstandsverbindungspunkts ($K_3$) des zweiten Brückenzweiges (40) ist, wenn das Bauelement (22) seinen Maximalwiderstandswert ($R_{XMAX}$) aufweist.

13. Vorrichtung nach Anspruch 12, **dadurch gekennzeichnet, dass** das Bauelement (22) ein Transistor ist und dass der zu bestimmende Widerstand ($R_x$) der EIN-Widerstand (26) des Transistors ist.

14. Vorrichtung nach Anspruch 13, **dadurch gekennzeichnet, dass** der Transistor ein Verpolschutztransistor (22) oder ein eine lastschaltender Transistor einer elektrischen Schaltung ist.

15. Vorrichtung nach Anspruch 12, **dadurch gekennzeichnet, dass** das Bauelement (22) ein Widerstand ist.

16. Vorrichtung nach einem der Ansprüche 12 bis 15, **gekennzeichnet durch** eine Einrichtung (32, 50, 52) zur Vermessung der Differenzspannungen zwischen den Widerstandsverbindungspunkten ($K_1$, $K_2$, $K_3$).

17. Vorrichtung nach einem der Ansprüche 12 bis 16, **gekennzeichnet durch** einen Multiplexer (52) zum wahlweisen Weiterleiten einer der Messspannungenan eine Spannungsmesseinrichtung (50).

18. Vorrichtung nach einem der Ansprüche 12 bis 15, **gekennzeichnet durch** eine Einrichtung zum Vermessen von Einzelspannungen zwischen jeweils den Widerstandsverbindungspunkten ($K_1$, $K_2$, $K_3$) und einem gemeinsamen Bezugspotential und zur Subtraktion von jeweils zwei gemessenen Einzelspannungen.

19. Vorrichtung nach einem der Ansprüche 12 bis 18, **gekennzeichnet durch** einen A/D-Wandler (32) zur Messung der Spannungen.

20. Vorrichtung nach Anspruch 19, **gekennzeichnet durch** einen Umschalter (34) am Eingang des A/D-Wandlers (32) zur Nutzung des A/D-Wandlers (32) einerseits für Spannungsmessungen und andererseits für Messungen des Stroms **durch** das elektrische Bauelement (22), dessen Widerstandswert ($R_x$) zu bestimmen ist.

21. Vorrichtung nach einem der Ansprüche 12 bis 20, **gekennzeichnet durch** eine zentrale Steuereinheit (18) zum Steuern einzelner Komponenten der Vorrichtung.

22. Vorrichtung nach einem der Ansprüche 12 bis 21, **gekennzeichnet durch** einen Temperatursensor zur Erfassung der Umgebungstemperatur des elektrischen Bauelements (22), dessen Widerstandswert ($R_x$) zu bestimmen ist.

23. Elektrische Schaltung mit einer Vorrichtung zur Bestimmung des Widerstandswertes ($R_x$) eines elektrischen Bauelements (22) dieser Schaltung nach einem der Ansprüche 12 bis 22 zur Durchführung des Verfahrens nach einem der Ansprüche 1 bis 11.

$$R_{XMIN} \leq R_X \leq R_{XMAX}$$

$$\frac{R_{XMAX}}{R_R + R_{XMAX}} = \frac{R_1 + R_2}{R_1 + R_2 + R_3}$$

$$\frac{R_{XMIN}}{R_R + R_{XMIN}} = \frac{R_1}{R_1 + R_2 + R_3}$$

Fig.1

Fig.2

EP 1 450 167 A1

Fig.3

Fig.4

**Europäisches Patentamt**

# EUROPÄISCHER RECHERCHENBERICHT

Nummer der Anmeldung

EP 03 00 4023

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | US 3 150 315 A (SIMON FRED W) 22. September 1964 (1964-09-22) | 1,4, 6-12,15, 17,18, 22,23 | G01R17/10 |
| Y | * Spalte 1, Zeile 1 - Spalte 4, Zeile 73; Abbildungen 1-3 * --- | 2,3,5, 13,14, 16,19-21 | |
| Y | US 3 227 953 A (CERVENY WALTER J) 4. Januar 1966 (1966-01-04) * Spalte 1, Zeile 1 - Spalte 2, Zeile 62; Anspruch 1; Abbildung 1 * --- | 2,3,13, 14 | |
| Y | EP 0 215 190 A (HARTMANN & BRAUN AG) 25. März 1987 (1987-03-25) * Spalte 1, Zeile 42 - Spalte 2, Zeile 48; Abbildung 1 * --- | 5,19-21 | |
| Y | DE 943 072 C (STANDARD ELEK ZITAETS GES A G) 9. Mai 1956 (1956-05-09) | 16 | |
| A | * Seite 1, Spalte 1, Zeile 1 - Seite 3, Spalte 2, Zeile 89 * --- | 1 | **RECHERCHIERTE SACHGEBIETE (Int.Cl.7)** G01R |
| A | US 4 071 814 A (VOSS WILLIAM BAKER) 31. Januar 1978 (1978-01-31) * Abbildung 4 * --- | 1 | |
| A | US 1 951 461 A (WESLEY WILSON) 20. März 1934 (1934-03-20) * das ganze Dokument * ----- | 1 | |

Der vorliegende Recherchenbericht wurde für alle Patentansprüche erstellt

| Recherchenort | Abschlußdatum der Recherche | Prüfer |
|---|---|---|
| DEN HAAG | 10. Dezember 2003 | Koll, H |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 03 00 4023

In diesem Anhang sind die Mitglieder der Patentfamilien der im obengenannten europäischen Recherchenbericht angeführten
Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

10-12-2003

| Im Recherchenbericht angeführtes Patentdokument | | Datum der Veröffentlichung | Mitglied(er) der Patentfamilie | | Datum der Veröffentlichung |
|---|---|---|---|---|---|
| US 3150315 | A | 22-09-1964 | KEINE | | |
| US 3227953 | A | 04-01-1966 | KEINE | | |
| EP 0215190 | A | 25-03-1987 | DE | 3529824 C1 | 02-01-1987 |
| | | | CN | 86105151 A ,B | 18-02-1987 |
| | | | DE | 3663311 D1 | 15-06-1989 |
| | | | EP | 0215190 A1 | 25-03-1987 |
| | | | JP | 1622510 C | 25-10-1991 |
| | | | JP | 2050430 B | 02-11-1990 |
| | | | JP | 62044667 A | 26-02-1987 |
| DE 943072 | C | 09-05-1956 | KEINE | | |
| US 4071814 | A | 31-01-1978 | KEINE | | |
| US 1951461 | A | 20-03-1934 | KEINE | | |

EPO FORM P0461

Für nähere Einzelheiten zu diesem Anhang : siehe Amtsblatt des Europäischen Patentamts, Nr.12/82